# EUROPEAN PATENT SPECIFICATION

(11) **EP 3 732 536 B1**
(45) Date of publication and mention of the grant of the patent: **04.06.2025**
(21) Application number: 18830471.1
(22) Date of filing: 20.12.2018
(51) Int. Cl.: G03F 7/038

(54) **A NEGATIVE TONE LIFT OFF RESIST COMPOSITION COMPRISING AN ALKALI SOLUBLE RESIN AND CROSS LINKERS AND A METHOD FOR MANUFACTURING METAL FILM PATTERNS ON A SUBSTRATE**
NEGATIVTONABHEBUNGSRESISTZUSAMMENSETZUNG MIT EINEM ALKALILÖSLICHEN HARZ UND VERNETZERN UND VERFAHREN ZUR HERSTELLUNG VON METALLFILMMUSTERN AUF EINEM SUBSTRAT
COMPOSITION DE RÉSERVE NÉGATIVE POUR PROCÉDÉ LIFT OFF COMPRENANT UNE RÉSINE SOLUBLE DANS UN ALCALI ET DES AGENTS DE RÉTICULATION ET PROCÉDÉ DE FORMATION DE MOTIFS DE FILM MÉTALLIQUE SUR UN SUBSTRAT

(30) Priority: 28.12.2017 EP 17210931
(43) Date of publication of application: 04.11.2020
(73) Proprietor: Merck Patent GmbH, 64293 Darmstadt (DE)
(72) Inventor: KATAYAMA, Tomohide, Kakegawa-shi Shizuoka 437-1412 (JP); YANO, Tomotsugu, Kakegawa-shi Shizuoka 437-1412 (JP); KUBO, Masahiko, Kakegawa-shi Shizuoka 437-1412 (JP)
(74) Representative: Merck Patent Association
(86) International application number: PCT/EP2018/086082
(87) International publication number: WO 2019/129613

(56) References cited:
- EP-A1- 1 271 249
- EP-A1- 1 297 386
- WO-A1-01/61410
- WO-A1-2017/169807

## Description

### [Technical Field]

The present invention relates to a method for manufacturing metal film patterns on a substrate using a negative tone lift off resist composition comprising an alkali soluble resin and cross linkers. And the present invention relates to a method for a manufacturing a device comprising metal film patterns manufacturing method thereof.

### [Background Art]

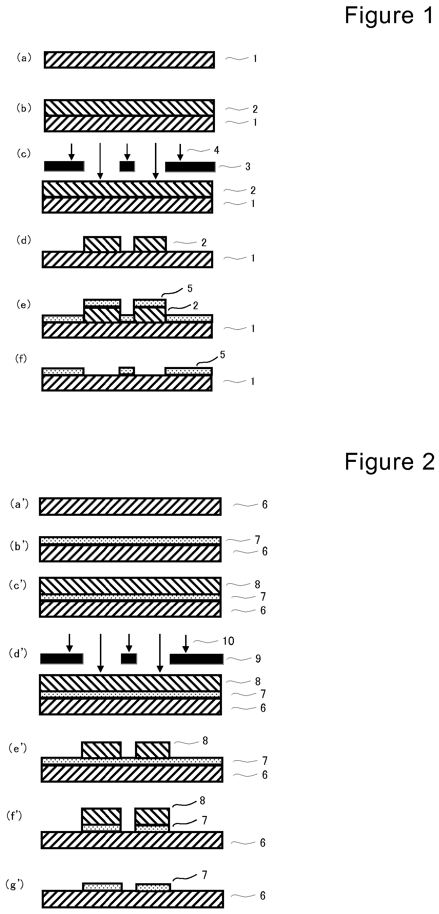

Because there is a tendency to require more miniaturized apparatuses with higher performance, more fine patterning is required in devices (for example, semiconductor device, FPD device). Lithography technology using a photoresist (hereinafter, simply referred to as "resist") is generally employed for fine processing. As exemplified in Fig 1, a lift-off process to make an electrode is known, which is characteristically removing unnecessary electrode portions on the patterned resist layer. On the contrary, a typical electrode etching process uses resist patterns as a mask to remove (typically, by dry etching) electrode under the resist patterns to obtain designed electrode patterns.

Under these circumstance, specific negative tone photoresist compositions for forming a lift off-pattern were studied, which are applied on underlayer and are developed with the underlayer simultaneously (Patent Literature 1).

And, negative-acting chemically amplified photoresist compositions were studied (Patent Literature 2), but lift off-patterning process was not tried in it.

Patent Literature 3 describes a chemically-amplified, negative-acting, radiation-sensitive photoresist composition that is developable in an alkaline medium, the photoresist comprising:
a) a phenolic film-forming polymeric binder resin having ring bonded hydroxyl groups;
b) a photoacid generator that forms an acid upon exposure to radiation, in an amount sufficient to initiate crosslinking of the film-forming binder resin;
c) a crosslinking agent that forms a carbonium ion upon exposure to the acid from step b) generated by exposure to radiation, and which comprises an etherified aminoplast polymer or oligomer;
d) a second crosslinking agent that forms a carbonium ion upon exposure to the acid from step b) generated by exposure to radiation, and which comprises either: 1) a hydroxy substituted-or 2) a hydroxy C1-C4 alkyl substituted-C1-C12 alkyl phenol, wherein the total amount of the crosslinking agents from steps c) and d) is an effective crosslinking amount; and
e) a photoresist solvent.

Patent Literature 4 describes
(A) an alkali-soluble resin,
(B) a component that crosslinks alkali soluble resin by irradiation with actinic rays or by irradiation with actinic rays and subsequent heat treatment, and
(C) a compound that contains a compound that absorbs actinic rays A composition comprising a resin composition (A) characterized in that (A) the alkali-soluble resin is a resin composition containing 30 to 95% by weight of polyvinyl phenol and 5 to 70% by weight of a novolac resin object.

Patent Literature 5 teaches a method of forming a reverse tapered resist pattern by use of a negative-working radiation sensitive resin composition, wherein the negative-working radiation sensitive resin composition comprises an alkali-soluble resin obtained by polycondensation of methylol bisphenol compounds represented by the general formula (I) 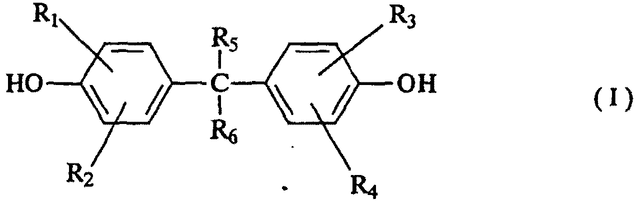 phenol compounds used as necessary, and aldehydes.

Patent Literature 6 describes a resist pattern formation method including:
a preparation step for preparing a radiation-sensitive resin composition containing an alkali-soluble resin (a),
a crosslinking component (b), and
a compound (c) that absorbs active radiation,
wherein the compound (c) content is greater than 1.0 part by mass relative to 100 parts by mass of the resin (a);
a coating step for forming a coating film of the radiation-sensitive resin composition on a substrate;
a first heat treatment step for heating the coating film at a first temperature; an exposure step for exposing the resulting resist film to active radiation; and
a second heat treatment step for maintaining the resist film under a second temperature condition after the exposure step begins.

### [Citation List]

### [Patent Literature]

[Patent Literature 1] JP2005-37414A
[Patent Literature 2] JP4799800B2
[Patent Literature 3] EP 1 297 386 A1
[Patent Literature 4] WO 01/61410 A1
[Patent Literature 5] EP 1 271 249 A1
[Patent Literature 6] WO 2017/169807 A1

### [Summary of Invention]

### [Technical Problem]

The present inventors thought that more fine resist patterns (e.g., having higher aspect ratio) face more strict conditions to be formed and to keep the pattern shapes in the later process. The inventors thought that decreasing defects (for example, pattern collapse) is advantageous as a negative tone lift off resist layer. And the inventors thought that good removability of more fine patterns is advantageous in lift off process.

Intensive studies were made by the inventors. And the inventors found a method for manufacturing metal film patterns on a substrate using a negative tone lift off resist compositions comprising an alkali soluble resin and cross linkers, which can form a negative tone lift off resist layers capable of exhibiting above properties.

### [Solution to Problem]

A negative tone lift off resist composition used in the method of the present invention comprises: (A) an alkali soluble resin; (B) cross linker represented by below formula (1); and (C) cross linker represented by below formula (2), wherein 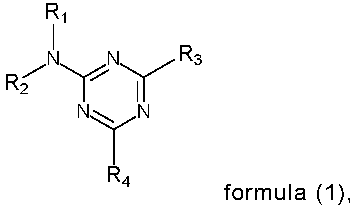
R₁ is C₂₋₈ alkoxylalkyl, R₂ is C₂₋₈ alkoxylalkyl,
R₃ is C₆₋₁₀ aryl unsubstituted or substituted by C₁₋₆ alkyl, C₁₋₈ alkyl unsubstituted or substituted by C₁₋₆ alkyl, or -NR₁R₂,
R₄ is C₆₋₁₀ aryl unsubstituted or substituted by C₁₋₆ alkyl, C₁₋₈ alkyl unsubstituted or substituted by C₁₋₆ alkyl, or -NR₁R₂, 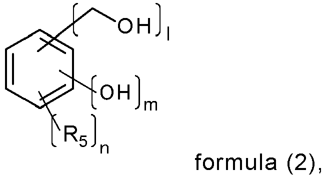
R₅ is C₁₋₂₀ alkyl unsubstituted or substituted by C₁₋₆ alkyl,
I is 1, 2, 3 or 4, m is 0, 1 or 2, n is 0, 1 or 2, and I+m+n ≤ 6.

The method for manufacturing metal film patterns on a substrate, comprises: forming a coating of the negative tone lift off resist composition above a substrate; curing the resist composition to form a resist layer; exposing the resist layer; developing the resist layer to form resist patterns; forming metal film on the resist patterns; and removing remained resist patterns and metal film on them. Here, "above a substrate" indicates that the negative tone lift off resist layer may be formed in direct contact with the substrate, or an underlayer may be interposed between the substrate and the negative tone lift off resist layer.

A method for manufacturing a device, comprises a manufacturing method of metal film patterns on a substrate, wherein the device is selected from the list consisting of a semiconductor device, a radio frequency module, a solar cell chip, an organic light emitting diode and an inorganic light emitting diode.

### [Effects of the Invention]

The negative tone lift off resist composition used in the method of the present invention has a good coatability. And the solutes in the composition exhibit good solubility in a solvent(s). Even if the pattern size are small, good shape of developed resist patterns made by the composition can be obtained and defects (e.g., pattern collapse) can be decreased. And even if the pattern size are small, clear removability of the resist patterns made by the composition can be obtained. Those are advantageous for more fine designed patterns for lift off process to make metal film patterns.

### [Brief Description of the Drawings]

Fig. 1 is a schematic profile of a lift off process
Fig. 2 is a schematic profile of an etching process
Fig. 3 is an explanatory drawing of a mask design used for resist patterning.

### Definitions

Herein later in this specification, below define symbols, units, abbreviations and terms mean below, unless explicitly limited or stated.

When a numerical range is specified herein using "-", "to" or "~", the numerical range includes both of the numbers indicated before and after "-", "to" or "~" and the unit is the same for the two numbers. For example, "5-25 mol%" means "5 mol% or more and 25 mol% or less".

The terms such as "C_{x-y}", " Cₓ-C_{y}", and "Cₓ" as used herein represent the number of carbon atoms in a molecule or substituent. For example, "C₁₋₆ alkyl" refers to an alkyl chain having 1-6 carbon atoms (such as methyl, ethyl, propyl, butyl, pentyl, and hexyl).

When a polymer as described herein has plural types of repeating units, these repeating units are copolymerized. The copolymerization may be any one selected from alternating copolymerization, random copolymerization, block copolymerization, graft copolymerization, and any combination of any of these. When polymer or resin is represented by chemical structure or formula, n, m and so on put beside brackets means repeating number.

The unit of temperatures as indicated herein is degree Celsius. For example, "20 degrees" means "20 degrees Celsius".

### Negative tone lift off resist composition

This method of the present invention employs a negative tone lift off resist composition comprising an alkali soluble resin and cross linkers. This negative tone resist composition is useful for a lift off process, which means metal film portions formed on developed resist layer (resist pattern walls) are removed in later process to obtain metal film patterns. Because the composition is a negative tone resist, the resist layer made by the composition has a character that exposed portion of the layer increase a resistance against dissolution by a developer, and that unexposed portion will be dissolved by the developer.

### Alkali soluble resin

The composition used in the method of the present invention comprises (A) an alkali soluble resin. This resin is preferably an alkali soluble binder resin. And this resin preferably comprises a novolac-based polymer or a polyhydroxystyrene-based polymer.

The alkali soluble resin preferably comprises unit A represented by below formula (3) and unit B represented by below formula (4). 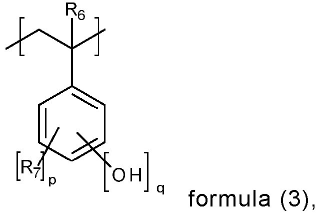
R₆ is hydrogen, C₁₋₆ alkyl, halogen, or cyano. R₆ is preferably hydrogen, methyl, ethyl, isopropyl, butyl, fluorine or cyano, more preferably hydrogen, methyl or fluorine, further preferably hydrogen. It is preferably embodiment that -OH bonds to para position at the phenyl.
R₇ is C₁₋₆ alkyl, hydroxy, halogen, or cyano. R₇ is preferably methyl, ethyl, isopropyl, butyl, fluorine or cyano, more preferably methyl or fluorine, further preferably methyl.
p is 0, 1, 2, 3 or 4. p is preferably 0, 1 or 2, more preferably 0.
q is 1, 2 or 3. q is preferably 1 or 2, more preferably 1.
p+q ≤ 5 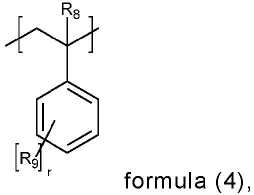
R₈ is hydrogen, C₁₋₆ alkyl, halogen, or cyano. R₈ is preferably hydrogen, methyl, ethyl, isopropyl, butyl, fluorine or cyano, more preferably hydrogen, methyl or fluorine, further preferably hydrogen.
R₉ is C₁₋₆ alkyl, halogen, or cyano. R₉ is preferably methyl, ethyl, isopropyl, butyl, fluorine or cyano, more preferably methyl or fluorine, further preferably methyl.
r is 0, 1, 2, 3, 4 or 5. r is preferably 0, 1 or 2, more preferably 0.

The alkali soluble resin of the composition used in the method of the present invention may comprise or may not comprise a repeating unit other than the repeating unit A and unit B. It is preferably embodiment that the alkali soluble resin of the composition does not comprise a repeating unit other than the repeating unit A and unit B.

Preferably, in all the repeating units in the alkali soluble resin, the concentration of the repeating unit A is 70 to 98 mol%, and the concentration of the repeating unit B is 2 to 30 mol%. More preferably, in all the repeating units in the alkali soluble resin, the concentration of the repeating unit A is 85 to 95 mol%, and the concentration of the repeating unit B is 5 to 15 mol%. Incorporating unit B in the alkali soluble resin is thought as advantageous for resist pattern formation and/or inhibiting pattern collapses.

In the present application, the weight average molecular weight (Mw) can be measured by gel permeation chromatography (GPC). In a suitable example of this measurement, a GPC column is set to 40 degrees Celsius; 0.6 mL/min of tetrahydrofuran is used as an elution solvent; and monodisperse polystyrene is used as a standard.

As one aspect of the invention, the weight average molecular weight (Mw) of the alkali soluble resin of the composition is preferably 2,000 to 100,000, more preferably 5,000 to 50,000, further preferably 5,000 to 20,000, further more preferably 8,000 to 10,000.

The mass ratio of the (A) alkali soluble resin to the total mass of the negative tone lift off resist composition is preferably 5 - 50 mass %, more preferably 8 - 40 mass %, further preferably 10 - 25 mass %. The formed resist layer thickness can be extended by adding more solid components (can be mainly occupied by the alkali soluble resin) in the composition.

### Cross linker represented by formula (1)

In a negative tone resist, resin and a cross linker(s) causes cross linking reactions by e.g., the heat of a post-exposure bake. And the solubility of the exposed potion of the resist layer changes. The composition used in the method of the present invention comprises (B) cross linker represented by below formula (1), and (C) cross linker represented by below formula (2). The inventors found that incorporating these cross linkers in a composition results in resist patterns exhibiting good properties of pattern shape forming and removability. As one aspect of the present invention, the composition may comprise or may not comprise a cross linker other than (B) cross linker represented by below formula (1) and (C) cross linker represented by below formula (2). It is a preferred embodiment that the composition does not comprise a cross linker other than (B) cross linker represented by below formula (1), and (C) cross linker represented by below formula (2).

The (B) cross linker of the composition is represented by below formula (1).

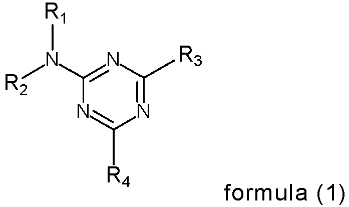

R₁ is C₂₋₈ alkoxylalkyl. R₁ is preferably C₂₋₄ methoxyl alkyl, more preferably -CH₂-O-CH₃.

R₂ is C₂₋₈ alkoxylalkyl. R₂ is preferably C₂₋₄ methoxyl alkyl, more preferably -CH₂-O-CH₃.

R₃ is C₆₋₁₀ aryl unsubstituted or substituted by C₁₋₆ alkyl, C₁₋₈ alkyl unsubstituted or substituted by C₁₋₆ alkyl, or -NR₁R₂. C₆₋₁₀ aryl of R₃ is preferably phenyl or naphthyl, more preferably phenyl. C₁₋₈ alkyl of R₃ is preferably methyl, ethyl, propyl, butyl, pentyl, or hexyl, more preferably methyl, or butyl. C₁₋₆ alkyl substituting C₆₋₁₀ aryl or C₁₋₈ alkyl of R₃ is preferably methyl, ethyl, isopropyl, or butyl, more preferably methyl. Unsubstituted C₆₋₁₀ aryl and C₁₋₈ alkyl of R₃ are further preferable.

Further more preferably R₃ is -NR₁R₂. Definitions and preferred embodiments of R₁and R₂ are each independently same to described above.

R₄ is C₆₋₁₀ aryl unsubstituted or substituted by C₁₋₆ alkyl, C₁₋₈ alkyl unsubstituted or substituted by C₁₋₆ alkyl, or -NR₁R₂. C₆₋₁₀ aryl of R₄ is preferably phenyl or naphthyl, more preferably phenyl. C₁₋₈ alkyl of R₄ is preferably methyl, ethyl, propyl, butyl, pentyl, or hexyl, more preferably methyl, or butyl. C₁₋₆ alkyl substituting C₆₋₁₀ aryl or C₁₋₈ alkyl of R₄ is preferably methyl, ethyl, isopropyl, or butyl, more preferably methyl. Unsubstituted C₆₋₁₀ aryl and C₁₋₈ alkyl of R₄ are further preferable.

Further more preferably R₄ is -NR₁R₂. Definitions and preferred embodiments of R₁and R₂ are each independently same to described above.

Exemplified embodiments of (B) cross linker represented by formula (1) are described below, but only for illustrative purpose.

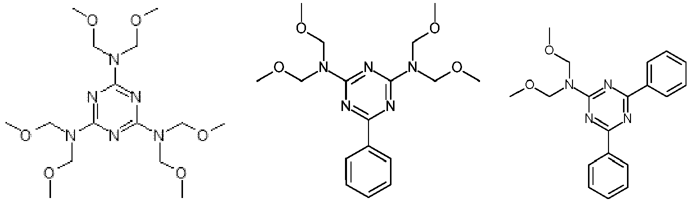

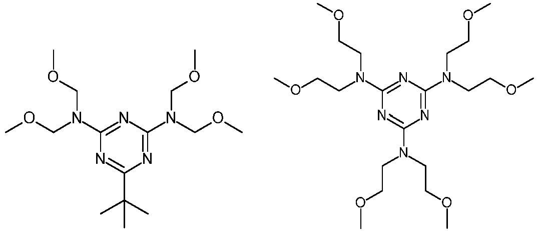

It is one embodiment of the composition that the mass ratio of the (B) cross linker to the mass of the (A) alkali soluble resin is preferably 0.10 - 8 mass %, more preferably 0.30 - 5 mass %, further preferably 0.50 - 2 mass %, further more preferably 0.65 - 1.31 mass %.

### Cross linker represented by formula (2)

The (C) cross linker of the composition used in the method of the present invention is represented by below formula (2).

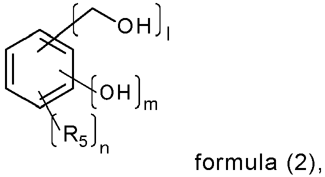

R₅ is C₁₋₂₀ alkyl unsubstituted or substituted by C₁₋₆ alkyl. C₁₋₂₀ alkyl of R₅ can be liner alkyl or branched alkyl. C₁₋₂₀ alkyl of R₅ is preferably C₁₋₁₀ alkyl, more preferably methyl, ethyl, propyl, butyl, pentyl, hexyl, heptyl, octyl, or -C(CH₃)₂-CH₂-C(CH₃)₃, further preferably -C(CH₃)₂-CH₂-C(CH₃)₃. C₁₋₆ alkyl substituting C₁₋₂₀ alkyl of R₅ is preferably methyl, ethyl, isopropyl, or butyl, more preferably methyl. Unsubstituted C₁₋₂₀ alkyl of R₅ is further preferable.

I is 1, 2, 3 or 4. l is preferably 2 or 3, more preferably 2.

m is 0, 1 or 2. m is preferably 0 or 1, more preferably 1.

n is 0, 1 or 2, and l+m+n ≤ 6. n is preferably 1.

Exemplified embodiments of (C) cross linker represented by formula (2) are described below, but only for illustrative purpose.

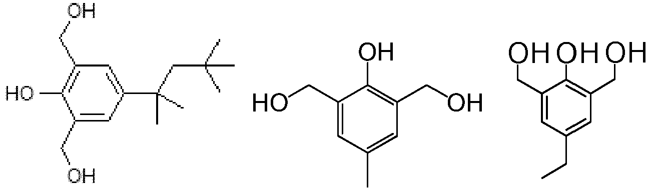

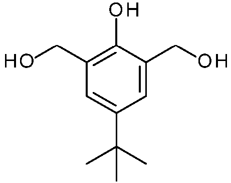

It is one embodiment of the composition used in the method of the present invention that the mass ratio of the (C) cross linker to the mass of the (A) alkali soluble resin is preferably 0.50 - 40 mass %, more preferably 1.0 - 30 mass %, further preferably 4.0 - 15 mass %, further preferably 5.5 - 8.5 mass %. As one aspect of the present invention, the resist layer made by the composition used in the method of the present invention with any one of the above amounts of (C) cross linker is good at pattern shape and removability.

### Solvent

The composition used in the method of the present invention can comprise a solvent. It is one embodiment that the solvent used in the present invention can comprise for example water and organic solvent. And the organic solvent in the composition can comprise at least one selected from the group consisting of aliphatic hydrocarbon solvents, aromatic hydrocarbon solvents, monoalcohol solvents, polyol solvents, ketone solvents, ether solvents, ester solvents, nitrogen-containing solvents, and sulfur-containing solvents. Any combination of any of these organic solvents can be used.

Examples of the organic solvents include: aliphatic hydrocarbon solvents such as n-pentane, i-pentane, n-hexane, i-hexane, n-heptane, i-heptane, cyclohexane, and methylcyclohexane; aromatic hydrocarbon solvents such as benzene, toluene, xylene, ethylbenzene, trimethylbenzene, methylethylbenzene, n-propylbenzene, i-propylbenzene, diethylbenzene, and i-butylbenzene,; monoalcohol solvents such as methanol, ethanol, n-propanol, i-propanol, n-butanol, i-butanol, sec-butanol, t-butanol, n-pentanol, i-pentanol, 2-methylbutanol, 2-ethylhexanol, n-nonyl alcohol, 2,6-dimethylheptanol-4, n-decanol, cyclohexanol, benzyl alcohol, phenylmethylcarbinol, diacetone alcohol, and cresol; polyol solvents such as ethylene glycol, propylene glycol, 1,3-butylene glycol, diethylene glycol, dipropylene glycol, triethylene glycol, tripropylene glycol, and glycerin; ketone solvents such as acetone, methyl ethyl ketone, methyl n-propyl ketone, methyl n-butyl ketone, diethyl ketone, trimethylnonanone, cyclohexanone, cyclopentanone, methylcyclohexanone, 2,4-pentanedione, acetonylacetone, acetophenone, and fenchone; ether solvents such as ethyl ether, i-propyl ether, n-butyl ether, n-hexyl ether, 2-ethylhexyl ether, dimethyldioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene glycol mono-2-ethylbutyl ether, ethylene glycol dibutyl ether, diethylene glycol monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, propylene glycol monomethyl ether (PGME), propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, and 2-methyltetrahydrofuran; ester solvents such as diethyl carbonate, methyl acetate, ethyl acetate, γ-butyrolactone, γ-valerolactone, n-propyl acetate, i-propyl acetate, n-butyl acetate, i-butyl acetate, n-butyl propionate, methyl lactate, ethyl lactate (EL), γ-butyrolactone, n-butyl lactate, n-amyl lactate, diethyl malonate, dimethyl phthalate, diethyl phthalate, propylene glycol 1-monomethyl ether 2-acetate (PGMEA), propylene glycol monoethyl ether acetate, and propylene glycol monopropyl ether acetate; nitrogen-containing solvents such as N-methylformamide,; and sulfur-containing solvents such as dimethyl sulfide. Any mixture of any of these solvents can also be used.

In particular, cyclohexanone, cyclopentanone, propylene glycol monomethyl ether, propylene glycol monoethyl ether, propylene glycol monopropyl ether, propylene glycol monobutyl ether, propylene glycol dimethyl ether, propylene glycol diethyl ether, propylene glycol 1-monomethyl ether 2-acetate, propylene glycol monoethyl ether acetate, propylene glycol monopropyl ether acetate, γ-butyrolactone, ethyl lactate, and any mixture of any of these are preferred in terms of the storage stability of the solution.

In terms of the solubility of the solute, propylene glycol monomethyl ether, propylene glycol 1-monomethyl ether 2-acetate, ethyl lactate, and a mixture of any two solvents selected therefrom are preferred. For this purpose, propylene glycol 1-monomethyl ether 2-acetate is more preferable as solvent.

The amount of the organic solvents (or the total amount of plurality of organic solvents) is preferably 60-95mass %, more preferably 70-90mass %, and further preferably 70-80mass % relative to the total amount of the composition. The solvents preferably comprise an organic solvent, and the amount of water in the composition is preferably 0.1mass % or less and further preferably 0.01mass % or less. Given the relationship with another layer or coating, it is preferable for the solvents to be free of water. As one aspect of the present invention, the amount of water in the composition is preferably 0.00mass %.

### Photo Acid Generator

At radiation exposed portions of a negative tone resist composition, a photo acid generator (PAG) receive radiation and generate acid, which catalyze cross linking reactions of resin and cross linker(s).

PAG comprised in the composition used in the method of the present invention can be selected from the group consisting of sulfonic acid derivative, diazomethane compound, onium salt, sulfone imide compound, disulfonic compound, nitrobenzyl compound, benzoin tosylate compound, iron arene complex compound, halogen-containing triazine compound, acetophenone derivative, cyano-containing oxime sulfonate, and any combination of any of these. It is preferable embodiment of PAG in the composition is sulfonic acid or onium salt.

One embodiment of sulfonic acid derivative is below compound.

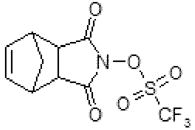

Onium salt is preferably sulfonium salt. One embodiment of sulfonic salt is below compound.

C₄F₉SO₃⁻

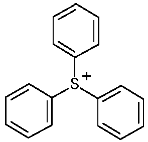

Exemplified embodiments of PAG are described below, but only for illustrative purpose.

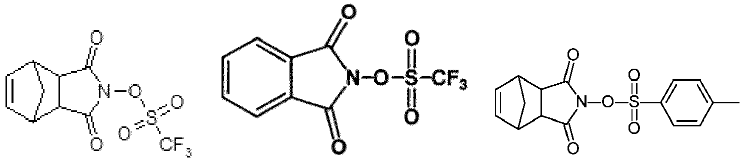

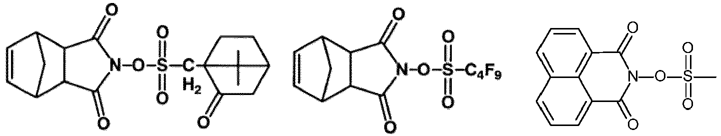

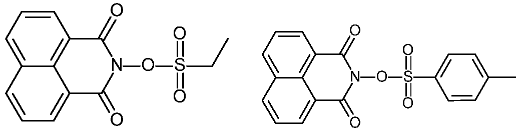

C₄F₉SO₃⁻

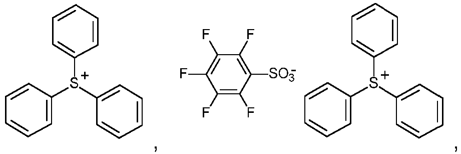

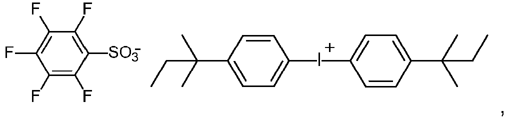

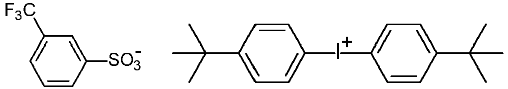

It is one embodiment of the composition that the mass ratio of the PAG to the mass of the (A) alkali soluble resin is preferably 1 - 20 mass %, more preferably 1 - 20 mass%, further preferably 5 - 15 mass%, further more preferably 7 - 12 mass%.

### Quencher

The composition used in the method of the present invention can further comprise a single or plurality of additives. As one aspect of the present invention, an additive is a quencher, which is useful for improve properties such as the resist pattern shapes and the long term stability (the post exposure stability of the latent image formed by the pattern-wise exposure of the resist layer). As a quencher, an amine is preferred, and more specifically, a secondary aliphatic amine or tertiary aliphatic amine can be used. Here, an aliphatic amine refers to C₂₋₉ alkyl or C₂₋₉ alkyl alcohol amine. And examples of these secondary and tertiary aliphatic amines include trimethylamine, diethylamine, triethylamine, di-n-propylamine, tri-n-propylamine, triisopropylamine, tributylamine, tripentylamine, trioctylamine, diethanolamine, and triethanolamine. And of these, tertiary aliphatic amines with an C₃₋₆ alkyl alcohol is more preferable.

It is one embodiment of the composition that the mass ratio of the quencher to the mass of the (A) alkali soluble resin is preferably 0 - 10 mass %, more preferably 0.01 - 8 mass%, further preferably 0.1 - 5 mass%.

### Surfactant

The composition used in the method of the present invention can comprise a surfactant, which is useful for decreasing pin hole or striation in a coating, and for increasing coatability and/or solubility of a composition. The amount of the surfactant (or the total amount of plurality of surfactants) is preferably 0-5mass %, more preferably 0.01-3mass %, further preferably 0.1 - 1 mass % relative to the mass of the (A) alkali soluble resin. It is also one preferable embodiment of the invention that the composition does not comprise any surfactant (0 mass %).

Examples of the surfactant include: polyoxyethylene alkyl ether compounds such as polyoxyethylene lauryl ether, polyoxyethylene stearyl ether, and polyoxyethylene oleyl ether; polyoxyethylene alkylaryl ether compounds such as polyoxyethylene octylphenol ether and polyoxyethylene nonylphenol ether; polyoxyethylene-polyoxypropylene block copolymer compounds; sorbitan fatty acid ester compounds such as sorbitan monolaurate, sorbitan monopalmitate, sorbitan monostearate, sorbitan trioleate, and sorbitan tristearate; and polyoxyethylene sorbitan fatty acid ester compounds such as polyoxyethylene sorbitan monolaurate, polyoxyethylene sorbitan monopalmitate, polyoxyethylene sorbitan monostearate, and polyoxyethylene sorbitan tristearate. Other examples of the surfactant include: fluorosurfactants such as EFTOP (trade name) EF301, EF303, and EF352 (manufactured by Tohkem Products Corporation), MEGAFACE (trade name) F171, F173, R-08, R-30, and R-2011 (manufactured by DIC Corporation), Fluorad FC430 and FC431 (manufactured by Sumitomo 3M Limited), AsahiGuard (trade name) AG710 (manufactured by Asahi Glass Co., Ltd.), and SURFLON S-382, SC101, SC102, SC103, SC104, SC105, and SC106 (manufactured by Asahi Glass Co., Ltd.); and organosiloxane polymers such as KP341 (manufactured by Shin-Etsu Chemical Co., Ltd.).

### Other Components

To the composition used in the method of the present invention, there may be further added other components such as a dye (preferably monomeric dye), a polymerization initiator, a contrast enhancer, acid, a radical generator, an agent for enhancing the adhesion to substrates, a lubricating agent, a lower alcohol (C₁₋₆ alcohol), a surface leveling agent, an anti-foaming agent, a preservative agent, and any combination of any of these. Components known as above can be used in the composition, for example known dye (e.g., azo dye, polycyclic aromatic hydrocarbon dye, aromatic hydrocarbon derivative dye, alcohol derivative dye, or methylol derivative dye) can be used in the composition, including those disclosed in U.S. publication WO2001/61410.

The amount of other component (or the total amount of plurality of other components) in the composition is preferably 0.01-10% by mass and more preferably 0.1-5% by mass relative to the mass of the (A) alkali soluble resin. As one aspect of the present invention, the composition contains none (0% by mass) of these components.

### Lift off process

One exemplary process embodiment of the lift off patterning process is illustrated in a schematic diagram of Figure 1. As shown in (a), a substrate is prepared, and then the resist composition is applied on the substrate and obtained as resist layer (shown in (b)). Next, exposure with light radiation through a designed mask as shown in (c). Then resist layer is developed to form resist patterns as shown in (d). The resist patterns have walls and trenches.

For the later removing process, a resist pattern with a reverse taper profile is preferable. For example, the resist patterns have such a good reverse taper profile that the substrate and the side of resist pattern wall preferably form an angle of less than 90 degrees (more preferably on or more than 55 degrees and less than 90 degrees, further preferably 55-80 degrees). The angle can be measured by a cross section photo by SEM.

Then, metal is applied (preferably deposited) on the resist patterns to form a metal film as shown in (e). The metal film is preferably an electrode. The metal film is formed on resist pattern walls and trenches. It is preferable that the resist layer has sufficient thickness to make a gap between the metal film on the wall and the trench so that resist layer remover can invade through the gap.

And the resist patterns and metal film on them are removed as shown in (f) (preferably removed by a resist layer remover solution) to obtain metal film patterns the substrate. In here, metal films formed on walls of resist patterns are removed, so that designed metal film patterns formed on trenches of resist patterns remain.

For comparison, the resist etching process in a schematic diagram of Figure 2 is described briefly below. (a') shows preparation a substrate. (b') shows forming metal film (e.g., electrode), and (c') shows forming resist layer on the metal film. (d') shows exposure through a mask, and (e') shows development to form resist patterns. (f') shows dry etch to remove bared metal film portion, and (g') shows removing remained resist patterns on remained metal film portion

### Formation of resist layer

A negative tone lift off resist composition is applied above a substrate. Before this apply, the substrate surface can be pre-treated, for example by 1,1,1,3,3,3-hexamethyldisilazane solution. The negative tone resist composition undergoes a reaction under irradiation and whose - irradiated portion has an increased resistance against dissolution by a developer. A publicly known method can be used for the application, for example spin coating. And the applied resist composition is baked to remove the solvent in the composition, thereby forming a resist layer. The baking temperature can vary depending on the composition to be used, but is preferably 70 - 150°C (more preferably 90 - 150°C, further preferably 100 - 140°C). It can be carried out for 10 - 180 seconds, preferably for 30 - 90 **seconds in** the case of on a hot plate, or for 1 to 30 minutes in case of in a hot gas atmosphere (for example in a clean oven).

The formed resist layer has a thickness of 0.40 - 5.00 µm preferably (0.40 - 3.00 µm more preferably, 0.50 - 2.00 µm further preferably).

In the method for manufacturing resist patterns of the invention, an underlayer may be interposed between the substrate and the resist coating so that the substrate and the resist coating are not in direct contact with each other. Examples of the underlayer include a bottom anti-reflecting coating (BARC layer), an inorganic hard mask underlayer (such as a silicon oxide coating, silicon nitride coating, or silicon oxynitride coating), and an adhesive coating. The underlayer may consist of a single layer or plurality of layers. Because of its good removability of the resist layer according to the invention, it is preferable embodiment that the resist layer is formed on a substrate without underlayer, and it can reduce unintended risk that underlayer (e.g., BARC) is dissolved during resist development that can cause process control difficult.

Other layer(s) (for example top anti-reflective coating, TARC) may be formed on the resist coating.

### Resist Patterning

The resist coating is exposed through a given mask. The wavelength of the light used for exposure is not particularly limited. The exposure is preferably performed with light having a wavelength of 13.5-248 nm. In particular, KrF excimer laser (wavelength: 248 nm), ArF excimer laser (wavelength: 193 nm), or extreme ultraviolet light (wavelength: 13.5 nm) can be used, and KrF excimer laser is more preferred. These wavelengths may vary within ±1%. Because the resist patterns made by the method according to the invention can form good shape and can exhibit good removability, more fine designed mask can be used. For example, mask comprising on or less than 1.0 µm line-space width can be preferably used, and less than 1.0 µm line-space width can be more preferably used.

The exposure can, if desired, be followed by a post-exposure bake. The temperature for the post-exposure bake is selected from the range of 80-150°C, preferably 100-140°C, and the heating time for the post-exposure bake is selected from the range of 0.3-5 minutes, preferably 0.5-2 minutes.

Next, development is performed with a developer. The unexposed portion of the negative tone lift off resist layer is removed by the development, resulting in the formation of resist patterns. A 2.38mass % (±1% concentration change accepted) aqueous TMAH solution is preferred as the developer used for the development in the resist patterns formation. An additive such as a surfactant can be added to the developer. The temperature of the developer is typically selected from the range of 5-50°C, preferably 25-40°C, and the development time is typically selected from the range of 10-300 seconds, preferably 30-90 seconds. As the developing method, publicly known methods such as paddle development can be used. It is preferable that resist layer is effectively removed and not remained at resist pattern trench portions.

After development, the resist patterns can be cleaned by water or cleaning solution as replacing developer with the water and/or cleaning solution. Then, the substrate can be dried, for example by a spin-dry method.

### Manufacturing metal film patterns on a substrate

Metal is applied on resist patterns to form metal film. Known methods can be used. Deposition and coating are preferable (vapor deposition is more preferable). Metal oxide is included in the metal. It is preferable that metal film has good conductivity. A single and plurality of mixed metals can be used. It is preferable that the thickness of formed metal film is effectively smaller than the thickness of resist pattern walls (preferably -80 to -20 % of thickness, more preferably -70 to -30 % of thickness), for making gap which resist layer remover can invade through to reach resist pattern walls.

Resist patterns and metal film on them are removed to obtain metal film patterns on the substrate (in narrow sense, this step can be call as lift-off). Metal film formed on walls of resist patterns are removed, so that designed metal film patterns formed on trenches of resist patterns are remained. Known method can be used for this removing, for example resist layer remover. One embodiment of a resist layer remover is AZ Remover 700 (Merck Performance Materials Itd). Patterned metal film is preferably electrode on substrate, which can be used to make a device in later process.

### Device Manufacturing

Subsequently, the substrate, if necessary, is further processed to form a device. Such further processing can be done by using a known method. After formation of the device, the substrate, if necessary, is cut into chips, which are connected to a leadframe and packaged with a resin.

The device is a semiconductor device, a radio frequency module, solar cell chip, organic light emitting diode and inorganic light emitting diode. One preferable embodiment of the device of this invention is a semiconductor device. The other preferable embodiment of the device of this invention is a radio frequency module, which can be made of a transmitter (including IC chip) and a receiver.

### Examples

Hereinafter, the present invention will be described with working examples. The term "part(s)" as used in the following description refers to part(s) by mass, unless otherwise stated.

### Preparation example 1 of working composition 1

Each of the components described below were prepared and added to the solvent (Propylene Glycol 1-Monomethyl Ether 2-Acetate, PGMEA). Polymer A (21.0867 g), cross linker A (1.1826 g), crosslinking agent B (0.1376 g), PAG A (1.527 g) and surfactant (0.0211 g, MegafacR2011, DIC Corp.). Each solution was stirred and confirmed that each solute was dissolved. All solutions were mixed and PGMEA was added until 100.0 g as a whole composition weight. The obtained composition was denoted by as working composition 1 in below Table 1. 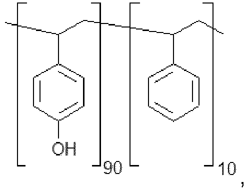 Polymer A (MARUKA LYNCUR CST-90, Maruzen petrochemical co., Itd.) 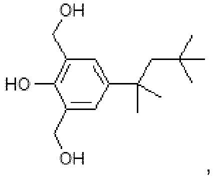 Cross linker A, (DML-POP, Honshu Chemical Industry co., ltd.) 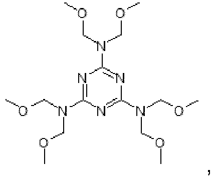 Cross linker B (CYMEL^{®} 301, Allnex Japan Inc.) 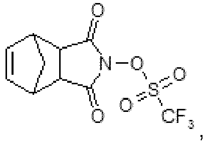 PAG A (MDT Sensitizer, Heraeus Precious Metals North America Daychem LLC)

**[Table 1]**

| | Polymer A (g) | X linker A (g) | X linker B (g) | PAG A (9) | Surfactant (9) |
|---|---|---|---|---|---|
| Working composition1 | 21.0867 | 1.1826 | 0.1376 | 1.527 | 0.0211 |
| Comp. composition1 | 21.2083 | 1.1895 | 0 | 1.581 | 0.0212 |
| Working composition2 | 21.1473 | 1.186 | 0.069 | 1.5765 | 0.0211 |
| Working composition3 | 21.1109 | 1.184 | 0.1102 | 1.5378 | 0.0211 |
| Working composition4 | 21.0264 | 1.1793 | 0.2058 | 1.5675 | 0.021 |
| Working composition5 | 20.9665 | 1.1759 | 0.2737 | 1.563 | 0.021 |
| Working composition6 | 20.6139 | 1.1561 | 0.6726 | 1.5367 | 0.0206 |
| Comp. composition2 | 22.1796 | 0 | 0.1447 | 1.6534 | 0.0222 |
| Working composition7 | 20.5797 | 1.7313 | 0.1343 | 1.5342 | 0.0206 |
| Working composition8 | 20.0964 | 2.2542 | 0.1311 | 1.4981 | 0.0201 |
| Working composition9 | 17.6147 | 4.9396 | 0.115 | 1.3131 | 0.0176 |

| | | | | | |
|---|---|---|---|---|---|
| "Comp." in above table 1 means "Comparative". Same in herein later. "X linker " in above table 1 means "Cross linker". | | | | | |

### Preparation example 2-9 of working composition 2-9, and Comparative preparation example 1-2 of comparative composition 1-2

Preparations were carried out in the same manners as in Preparation Example 1, except for changing components and amounts as described in above table 1. And, working composition 2-10 and comparative composition 1-2 were obtained.

### Example of preparing a substrate for evaluation working composition 1

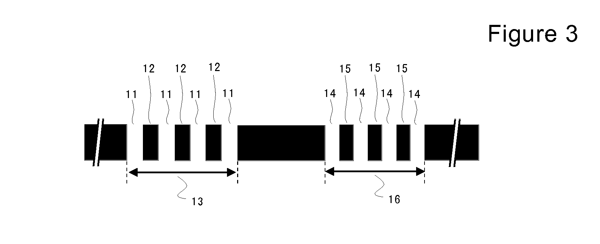

The substrate for evaluation used for following evaluation was prepared as shown below. The surface of a silicon substrate (SUMCO Corp., 8 inches) was treated with a 1,1,1,3,3,3-hexamethyldisilazane solution at 90°C for 60 seconds. The working composition 1 was spin-coated thereon and soft-baked at 130°C for 60 seconds, thereby forming a resist layer having a thickness of 1.55 µm on the substrate. This was exposed through a mask by an FPA-3000EX5 (Canon Inc). The used mask had a region with plural 1.0 µm lines and line:space = 1:1. And the mask had gradually narrowed lines and spaces regions located. Those lines width were 1.0 µm, 0.9 µm, 0.8 µm, 0.7 µm, 0.6 µm, 0.5 µm, 0.45 µm, 0.40 µm, 0.38 µm, 0.36 µm, 0.34 µm, 0.32 µm, 0.30 µm, 0.28 µm, 0.26 µm, 0.24 µm, 0.22 µm, 0.20 µm, 0.18 µm, 0.16 µm, 0.14 µm, 0.12 µm, and 0.10 µm. The mask has plural same width lines, and each line:space ratio were 1:1. For better understanding, the mask design is described in Figure 3. An inexact reduction scale is used in Figures 3 for better visuability.

This substrate was post-exposure baked (PEB) at 110°C for 60 seconds. Thereafter, the resist layer was subjected to puddle development for 60 seconds using a 2.38% tetramethylammonium hydroxide (TMAH) aqueous solution. In a state of a puddle developing solution being paddled on the substrate, pure water was started to flow onto the substrate. And with rotating the substrate, the puddle developing solution was replaced with pure water. Then, the substrate was rotated at 2,000 rpm, thereby spin-dried.

### Example of preparing substrates for evaluation working composition 2-9 and comparative composition 1-2

Each substrate preparation was carried out in the same manner as described above, except for changing working composition 1 with working composition 2-9 and comparative composition 1-2

### Evaluation example of resist pattern shapes

The shapes of resist patterns exposed through 0.7µm spaces on each above substrate were evaluated with a SEM instrument, SU8230 (Hitachi High-Technologies Corp.). Evaluation criteria were designated as follows.
A: Resist pattern collapse was not found.
B: Resist pattern collapse was found.

The evaluation results were shown in below Table 2.

**[Table 2]**

| | Resist pattern shapes | Removability |
|---|---|---|
| Working composition1 | A | A |
| Comp. composition1 | A | C |
| Working composition2 | A | B |
| Working composition3 | A | B |
| Working composition4 | A | A |
| Working composition5 | A | A |
| Working composition6 | A | B |
| Comp. composition2 | B | - |
| Working composition7 | A | A |
| Working composition8 | A | B |
| Working composition9 | A | A |

Substrates evaluated as A in Resist pattern shapes were evaluated in the following removability evaluation.

### Evaluation example of removability

20 mm x 20 mm segments cut from each substrate were prepared. These segments were baked at 110 °C for 90 seconds. Each segment was placed on the petri dish, far enough from the dish center. A resist layer remover (AZ Remover 700, Merck Performance Materials Itd) was slowly added in a petri dish. With mixing by a stirrer, the solution was heated until 70 °C. After 10 minutes mixing the solution, the segment was taken out. And the resist layer remover was washed off by a sufficient pure-water. And the segment was dried by a N₂ gas spraying

The place resist patterns located before removing was observed by an optical microscope, from 1.0 µm line-space exposed ones to gradually narrower ones. Evaluation criteria were designated as follows.
A: On and less than 0.4 µm line-space exposed resist patterns were removed clearly.
B: More than 0.4 µm and less than 1.0 µm line-space exposed resist patterns were removed clearly.
C: Less than 1.0 µm line-space exposed resist patterns were not removed clearly.

The evaluation results were shown in above Table 2. Resist patterns made from the working example compositions were able to be removed more clearly than the ones made from comparative composition 1.

### Preparation example 10 of working composition 10

Each component described below was prepared and added in solvent (PGMEA). Polymer A (12.158 g), cross linker A (1.36 g), crosslinking agent B (0.157 g), PAG B (1.313 g) and surfactant (0.012g, MegafacR2011). The solution was stirred and confirmed that each solute was dissolved. The solution was mixed and PGMEA was added until 100.0 g as a whole composition weight. Then working composition 10 was obtained.

C₄F₉SO₃⁻

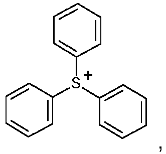

PAG B (TG-NONA, Toyo Gosei co., Ltd)

### Example of preparing a substrate for evaluation working composition 10, and evaluation of the resist pattern shapes on it

The substrate for evaluation used for following evaluation was prepared as shown below. The surface of a silicon substrate (SUMCO Corp., 8 inches) was treated with a 1,1,1,3,3,3-hexamethyldisilazane solution at 90°C for 60 seconds. The working composition 10 was spin-coated thereon and soft-baked at 130°C for 60 seconds, thereby forming a resist layer having a thickness of 0.515 µm on the substrate. This was exposed through a mask by an FPA-3000EX5. The used mask has line and space = 1:1, lines width were 0.7 µm.

This substrate was post-exposure baked (PEB) at 110°C for 60 seconds. Thereafter, the resist layer was subjected to puddle development for 60 seconds using a 2.38% TMAH aqueous solution. In a state of a puddle developing solution being paddled on the substrate, pure water was started to flow onto the substrate. And with rotating the substrate, the puddle developing solution was replaced with pure water. Then, the substrate was rotated at 2,000 rpm, thereby spin-dried.

The shapes of resist patterns on the above substrate were evaluated with a SEM instrument, SU8230. Evaluation criteria were designated as above. Resist pattern collapse was not found on it (A in the above criteria).

### [Reference Signs List]

1. Substrate
2. Resist layer
3. Mask
4. Radiation
5. Metal film
6. Substrate
7. Metal film
8. Resist layer
9. Mask
10. Radiation
11. 1.0 µm width line
12. 1.0 µm width space
13. A region with 1.0 µm width lines and line:spce=1:1
14. 0.9 µm width line
15. 0.9 µm width space
16. A region with 0.9 µm width lines and line:spce=1:1

## Claims

1. A method for manufacturing metal film patterns on a substrate, comprising :
forming a coating of a negative tone lift off resist composition above a substrate;
curing the resist composition to form a resist layer;
exposing the resist layer;
developing the resist layer to form resist patterns;
forming metal film on the resist patterns; and
removing remained resist patterns and metal film on them;
wherein the negative tone lift off resist composition comprises (A) an alkali soluble resin, (B) cross linker represented by below formula (1), and (C) cross linker represented by below formula (2), wherein 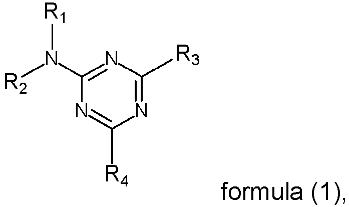
R₁ is C₂₋₈ alkoxylalkyl, R₂ is C₂₋₈ alkoxylalkyl,
R₃ is C₆₋₁₀ aryl unsubstituted or substituted by C₁₋₆ alkyl, C₁₋₈ alkyl unsubstituted or substituted by C₁₋₆ alkyl, or -NR₁R₂,
R₄ is C₆₋₁₀ aryl unsubstituted or substituted by C₁₋₆ alkyl, C₁₋₈ alkyl unsubstituted or substituted by C₁₋₆ alkyl, or -NR₁R₂, 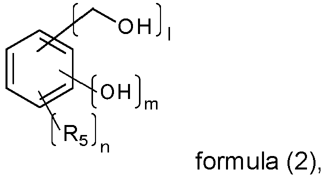
R₅ is C₁₋₂₀ alkyl unsubstituted or substituted by C₁₋₆ alkyl,
l is 1, 2, 3 or 4, m is 0, 1 or 2, n is 0, 1 or 2, and l+m+n ≤ 6.

2. The method for manufacturing metal film patterns on a substrate according to claim 1, wherein the (A) alkali soluble resin comprises unit A represented by below formula (3) and unit B represented by below formula (4), wherein 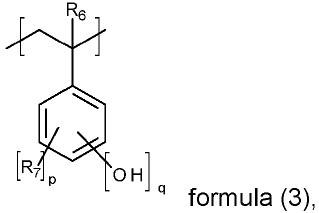
R₆ is hydrogen, C₁₋₆ alkyl, halogen, or cyano, R₇ is C₁₋₆ alkyl, hydroxy, halogen, or cyano, p is 0, 1, 2, 3 or 4, q is 1, 2 or 3, p+q ≤ 5 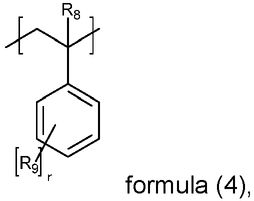
R₈ is hydrogen, C₁₋₆ alkyl, halogen, or cyano, R₉ is C₁₋₆ alkyl, halogen, or cyano, and r is 0, 1, 2, 3, 4 or 5.

3. The method for manufacturing metal film patterns on a substrate according to claim 1 or 2, wherein the weight average molecular weight (Mw) of the (A) alkali soluble resin is 2,000 to 100,000, measured by gel permeation chromatography.

4. The method for manufacturing metal film patterns on a substrate according to one or more of claims 1 to 3, wherein the mass ratio of the (A) alkali soluble resin to the total mass of the negative tone lift off resist composition is 5 - 50 mass %.

5. The method for manufacturing metal film patterns on a substrate according to one or more of claims 1 to 4, wherein the mass ratio of the (B) cross linker to the mass of (A) alkali soluble resin is 0.10 - 8 mass %, and
the mass ratio of the (C) cross linker to the mass of (A) alkali soluble resin is 0.50 - 40 mass %.

6. The method for manufacturing metal film patterns on a substrate according to one or more of claims 1 to 5, wherein the negative tone lift off resist composition further comprises a solvent, wherein the solvent is selected from the group consisting of aliphatic hydrocarbon solvent, aromatic hydrocarbon solvent, monoalcohol solvent, polyol solvent, ketone solvent, ether solvent, ester solvent, nitrogen-containing solvent, sulfur-containing solvent, and any combination of any of these.

7. The method for manufacturing metal film patterns on a substrate according to one or more of claims 1 to 6, wherein the negative tone lift off resist composition further comprises a photo acid generator, wherein the mass ratio of the photo acid generator to the mass of (A) alkali soluble resin is 1 - 20 mass %.

8. The method for manufacturing metal film patterns on a substrate according to one or more of claims 1 to 7, wherein the negative tone lift off resist composition comprises a photo acid generator wherein, the photo acid generator comprises at least one selected from the group consisting of sulfonic acid derivative, diazomethane compound, onium salt, sulfone imide compound, disulfonic compound, nitrobenzyl compound, benzoin tosylate compound, iron arene complex compound, halogen-containing triazine compound, acetophenone derivative, and cyano-containing oxime sulfonate.

9. The method for manufacturing metal film patterns on a substrate according to one or more of claims 1 to 8, wherein the negative tone lift off resist composition further comprises at least one additive selected from the group consisting of a quencher, a surfactant, dye, a contrast enhancer, acid, a radical generator, and an agent for enhancing adhesion to substrates.

10. A method for manufacturing a device, comprising a manufacturing method of metal film patterns on a substrate according to one or more of claims 1 to 9, wherein the device is selected from the list consisting of a semiconductor device, a radio frequency module, a solar cell chip, an organic light emitting diode and an inorganic light emitting diode.

## Patentansprüche

1. Verfahren zur Herstellung von Metallfilmstrukturen auf einem Substrat, umfassend:
Bilden einer Beschichtung aus einer Lift-off-Negativresist-Zusammensetzung auf einem Substrat;
Härten der Resistzusammensetzung zur Bildung einer Resistschicht;
Belichten der Resistschicht;
Entwickeln der Resistschicht zur Bildung von Resiststrukturen;
Bilden von Metallfilm auf den Resiststrukturen; und
Entfernen von restlichen Resiststrukturen und Metallfilm auf ihnen;
wobei die Lift-off-Negativresist-Zusammensetzung (A) ein alkalilösliches Harz, (B) durch die nachfolgende Formel (1) dargestellten Vernetzer und (C) durch die nachfolgende Formel (2) dargestellten Vernetzer enthält, wobei 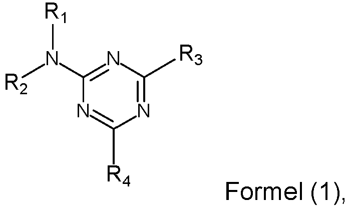
R₁ C₂₋₈-Alkoxyalkyl ist, R₂ C₂₋₈-Alkoxyalkyl ist,
R₃ C₆₋₁₀-Aryl, unsubstituiert oder durch C₁₋₆-Alkyl substituiert, C₁₋₈-Alkyl, unsubstituiert oder durch C₁₋₆-Alkyl substituiert, oder -NR₁R₂ ist,
R₄ C₆₋₁₀-Aryl, unsubstituiert oder durch C₁₋₆-Alkyl substituiert, C₁₋₈-Alkyl, unsubstituiert oder durch C₁₋₆-Alkyl substituiert, oder -NR₁R₂ ist, 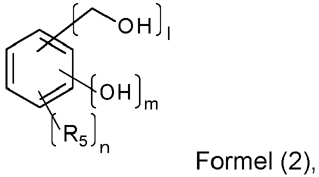
R₅ C₁₋₂₀-Alkyl, unsubstituiert oder durch C₁₋₆-Alkyl substituiert, ist, l 1, 2, 3 oder 4 ist, m 0, 1 oder 2 ist, n 0, 1 oder 2 ist, und I+m+n ≤ 6.

2. Verfahren zur Herstellung von Metallfilmstrukturen auf einem Substrat nach Anspruch 1, wobei das alkalilösliche Harz (A) die Einheit A, die durch nachstehende Formel (3) dargestellt wird, und die Einheit B, die durch nachstehende Formel (4) dargestellt wird, enthält, wobei 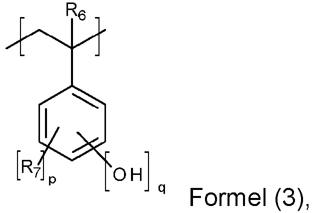
R₆ Wasserstoff, C₁₋₆-Alkyl, Halogen oder Cyano ist, R₇ C₁₋₆-Alkyl,
Hydroxy, Halogen oder Cyano ist, p 0, 1, 2, 3 oder 4 ist, q 1, 2 oder 3 ist, p+q ≤ 5, 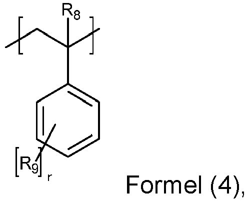
R₈ Wasserstoff, C₁₋₆-Alkyl, Halogen oder Cyano ist, R₉ C₁₋₆-Alkyl, Halogen oder Cyano ist und r 0, 1, 2, 3, 4 oder 5 ist.

3. Verfahren zur Herstellung von Metallfilmstrukturen auf einem Substrat nach Anspruch 1 oder 2, wobei das gewichtsmittlere Molekulargewicht (Mw) des alkalilöslichen Harzes (A) bei 2.000 bis 100.000 liegt, gemessen durch Gelpermeationschromatographie.

4. Verfahren zur Herstellung von Metallfilmstrukturen auf einem Substrat nach einem oder mehreren der Ansprüche 1 bis 3, wobei das Massenverhältnis des alkalilöslichen Harzes (A) zur Gesamtmasse der Lift-off-Negativresist-Zusammensetzung 5 - 50 Massen-% beträgt.

5. Verfahren zur Herstellung von Metallfilmstrukturen auf einem Substrat nach einem oder mehreren der Ansprüche 1 bis 4, wobei das Massenverhältnis des Vernetzers (B) zur Masse des alkalilöslichen Harzes (A) 0,10 - 8 Massen-% beträgt, und
das Massenverhältnis des Vernetzers (C) zur Masse des alkalilöslichen Harzes (A) 0,50 - 40 Massen-% beträgt.

6. Verfahren zur Herstellung von Metallfilmstrukturen auf einem Substrat nach einem oder mehreren der Ansprüche 1 bis 5, wobei die Lift-off-Negativresist-Zusammensetzung ferner ein Lösungsmittel enthält, wobei das Lösungsmittel aus der Gruppe bestehend aus aliphatischem Kohlenwasserstofflösungsmittel, aromatischem Kohlenwasserstofflösungsmittel, Monoalkohollösungsmittel, Polyollösungsmittel, Ketonlösungsmittel, Etherlösungsmittel, Esterlösungsmittel, stickstoffhaltigem Lösungsmittel, schwefelhaltigem Lösungsmittel, und beliebiger Kombination von beliebigen hiervon ausgewählt ist.

7. Verfahren zur Herstellung von Metallfilmstrukturen auf einem Substrat nach einem oder mehreren der Ansprüche 1 bis 6, wobei die Lift-off-Negativresist-Zusammensetzung ferner einen Photosäurebildner enthält, wobei das Massenverhältnis des Photosäurebildners zur Masse des alkalilöslichen Harzes (A) 1 - 20 Massen-% beträgt.

8. Verfahren zur Herstellung von Metallfilmstrukturen auf einem Substrat nach einem oder mehreren der Ansprüche 1 bis 7, wobei die Lift-off-Negativresist-Zusammensetzung einen Photosäurebildner enthält, wobei der Photosäurebildner mindestens eine Verbindung enthält, die aus der Gruppe bestehend aus Sulfonsäurederivat, Diazomethanverbindung, Oniumsalz, Sulfonimidverbindung, Disulfonverbindung, Nitrobenzylverbindung, Benzointosylatverbindung, Eisen-Aren-Komplexverbindung, halogenhaltiger Triazinverbindung, Acetophenonderivat und cyanohaltigem Oximsulfonat ausgewählt ist.

9. Verfahren zur Herstellung von Metallfilmstrukturen auf einem Substrat nach einem oder mehreren der Ansprüche 1 bis 8, wobei die Lift-off-Negativresist-Zusammensetzung ferner mindestens einen Zusatzstoff enthält, der aus der Gruppe bestehend aus einem Quencher, einem Tensid, einem Farbstoff, einem Kontrastverstärker, einer Säure, einem Radikalerzeuger und einem Mittel zur Verbesserung der Substrathaftung ausgewählt ist.

10. Verfahren zur Herstellung einer Vorrichtung, umfassend ein Herstellungsverfahren für Metallfilmstrukturen auf einem Substrat nach einem oder mehreren der Ansprüche 1 bis 9, wobei die Vorrichtung aus der Liste bestehend aus einer Halbleitervorrichtung, einem Radiofrequenzmodul, einem Solarzellenchip, einer organischen Leuchtdiode und einer anorganischen Leuchtdiode ausgewählt ist.

## Revendications

1. Méthode de fabrication de motifs de film métallique sur un substrat, comprenant :
la formation d'un revêtement d'une composition de résine photosensible lift-off à ton négatif au-dessus d'un substrat ;
le durcissement de la composition de résine photosensible afin de former une couche de résine photosensible ;
l'exposition de la couche de résine photosensible ;
le développement de la couche de résine photosensible afin de former des motifs de résine photosensible ;
la formation d'un film métallique sur les motifs de résine photosensible ; et
l'élimination des motifs de résine photosensible restants et du film métallique sur ceux-ci ;
dans laquelle la composition de résine photosensible lift-off à ton négatif comprend (A) une résine soluble dans les alcalis, (B) un agent de réticulation représenté par la formule (1) ci-après, et (C) un agent de réticulation représenté par la formule (2) ci-après, dans lesquelles 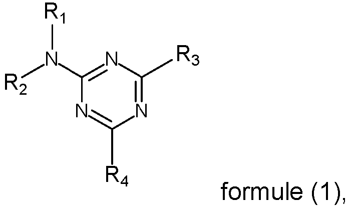
R₁ est C₂₋₈ alcoxyalkyle, R₂ est C₂₋₈ alcoxyalkyle,
R₃ est C₆₋₁₀ aryle non substitué ou substitué par C₁₋₆ alkyle, C₁₋₈ alkyle non substitué ou substitué par C₁₋₆ alkyle, ou -NR₁R₂,
R₄ est C₆₋₁₀ aryle non substitué ou substitué par C₁₋₆ alkyle, C₁₋₈ alkyle non substitué ou substitué par C₁₋₆ alkyle, ou -NR₁R₂, 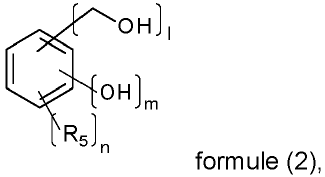
R₅ est C₁₋₂₀ alkyle non substitué ou substitué par C₁₋₆ alkyle,
l vaut 1, 2, 3 ou 4, m vaut 0, 1 ou 2, n vaut 0, 1 ou 2, et l+m+n ≤ 6.

2. Méthode de fabrication de motifs de film métallique sur un substrat selon la revendication 1, dans laquelle la résine soluble dans les alcalis (A) comprend un motif A représenté par la formule (3) ci-après et un motif B représenté par la formule (4) ci-après, dans lesquelles 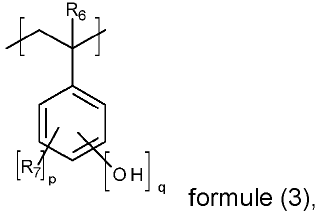
R₆ est hydrogène, C₁₋₆ alkyle, halogène, ou cyano, R₇ est C₁₋₆ alkyle, hydroxy, halogène, ou cyano, p vaut 0, 1, 2, 3 ou 4, q vaut 1, 2 ou 3, p+q ≤ 5, 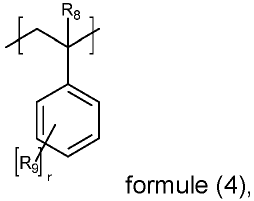
R₈ est hydrogène, C₁₋₆ alkyle, halogène, ou cyano, R₉ est C₁₋₆ alkyle, halogène, ou cyano, et r vaut 0, 1, 2, 3, 4 ou 5.

3. Méthode de fabrication de motifs de film métallique sur un substrat selon la revendication 1 ou 2, dans laquelle le poids moléculaire moyen en poids (Mw) de la résine soluble dans les alcalis (A) va de 2000 à 100 000, mesuré par chromatographie de perméation sur gel.

4. Méthode de fabrication de motifs de film métallique sur un substrat selon l'une ou plusieurs parmi les revendications 1 à 3, dans laquelle le rapport massique de la résine soluble dans les alcalis (A) à la masse totale de la composition de résine photosensible lift-off à ton négatif est de 5 - 50% en masse.

5. Méthode de fabrication de motifs de film métallique sur un substrat selon l'une ou plusieurs parmi les revendications 1 à 4, dans laquelle le rapport massique de l'agent de réticulation (B) à la masse de résine soluble dans les alcalis (A) est de 0,10 - 8% en masse, et
le rapport massique de l'agent de réticulation (C) à la masse de résine soluble dans les alcalis (A) est de 0,50 - 40% en masse.

6. Méthode de fabrication de motifs de film métallique sur un substrat selon l'une ou plusieurs parmi les revendications 1 à 5, dans laquelle la composition de résine photosensible lift-off à ton négatif comprend en outre un solvant, où le solvant est choisi dans le groupe constitué par un solvant hydrocarboné aliphatique, un solvant hydrocarboné aromatique, un solvant à base d'un mono-alcool, un solvant à base d'un polyol, un solvant à base d'une cétone, un solvant à base d'un éther, un solvant à base d'un ester, un solvant azoté, un solvant soufré, et une combinaison quelconque d'éléments quelconques parmi ceux-ci.

7. Méthode de fabrication de motifs de film métallique sur un substrat selon l'une ou plusieurs parmi les revendications 1 à 6, dans laquelle la composition de résine photosensible lift-off à ton négatif comprend en outre un générateur photo-acide, où le rapport massique du générateur photo-acide à la masse de résine soluble dans les alcalis (A) est de 1 - 20% en masse.

8. Méthode de fabrication de motifs de film métallique sur un substrat selon l'une ou plusieurs parmi les revendications 1 à 7, dans laquelle la composition de résine photosensible lift-off à ton négatif comprend un générateur photo-acide, où le générateur photo-acide comprend au moins un composé choisi dans le groupe constitué par un dérivé d'acide sulfo-nique, un composé de diazométhane, un sel d'onium, un composé de sulfone imide, un composé disulfonique, un composé de nitrobenzyle, un composé de tosylate de benzoïne, un composé complexe de fer et d'arène, un composé de triazine halogéné, un dérivé d'acétophénone et un sulfonate d'oxime à groupements cyano.

9. Méthode de fabrication de motifs de film métallique sur un substrat selon l'une ou plusieurs parmi les revendications 1 à 8, dans laquelle la composition de résine photosensible lift-off à ton négatif comprend en outre au moins un additif choisi dans le groupe constitué par un agent d'extinction, un agent tensioactif, un colorant, un agent améliorant le contraste, un acide, un générateur de radicaux, et un agent améliorant l'adhérence aux substrats.

10. Méthode de fabrication d'un dispositif, comprenant une méthode de fabrication de motifs de film métallique sur un substrat selon l'une ou plusieurs parmi les revendications 1 à 9, dans laquelle le dispositif est choisi dans la liste constituée par un dispositif semi-conducteur, un module radiofréquence, une puce de cellule solaire, une diode électroluminescente organique et une diode électroluminescente inorganique.
